Europäisches Patentamt

European Patent Office

Office européen des brevets

(11) Publication number: **0 242 962**
**A1**

# EUROPEAN PATENT APPLICATION

(21) Application number: 87302007.7

(51) Int. Cl.⁴: **H01L 23/48**

(22) Date of filing: 09.03.87

(30) Priority: 25.04.86 US 855907

(43) Date of publication of application:
**28.10.87 Bulletin 87/44**

(84) Designated Contracting States:
**DE FR GB NL**

(71) Applicant: **INMOS CORPORATION**
**P.O. Box 16000**
**Colorado Springs Colorado 80935(US)**

(72) Inventor: **Wilson, David S.**
**547 Lovell Gulch Road**
**Woodland Park Colorado 80863(US)**
Inventor: **Kiffe, Dennis O.**
**2605 Sunnywood Avenue**
**Woodland Park Colorado 80863(US)**

(74) Representative: **Needle, Jacqueline et al**
**PAGE, WHITE & FARRER 5 Plough Place New**
**Fetter Lane**
**London EC4A 1HY(GB)**

(54) **Offset pad semiconductor lead frame.**

(57) A lead frame for the manufacture of semiconductor devices having an offset die pad (57) positioned closer to a first carrier strip (59) of the lead frame than to a second carrier strip (61) of the lead frame. Die (42), such as memory chips, which are designed for end-only wire bonding, may be centred on the off-centre die pads. This enables bonding wires (50) to be used which are all substantially equal in length. Having the die centred also increases the efficiency of manufacture of semiconductor devices and increases the reliability of each semiconductor device.

FIG 2

FIG 4

EP 0 242 962 A1

# OFFSET PAD SEMICONDUCTOR LEAD FRAME

The present invention relates to a semiconductor lead frame.

Lead frames are used in the manufacture of semiconductor devices which are molded in some type of plastic or epoxy compound. Previous lead frames have a die pad centred between two parallel carrier strips. In standard dual inline package (D.I.P.) lead frames, the die pad provides a mount on which a semiconductor chip or die is positioned. After attaching the die to the die pad, wires are attached to contact points on the die surface from contact legs surrounding the die pad. This is the wire bonding process. The die, die pad, contact legs and connecting wires are then encased in a plastic or epoxy compound and the carrier strips are removed to form an assembled semiconductor package. In semiconductor manufacturing, the assembly yield is much higher if all wires are approximately the same length.

Some dies, such as memory chips, are designed for wire bonding only at two opposite ends of the die rather than having contact points on all four sides of the chip. Such dies, which accept wire connections on the ends only, require special placement techniques on a conventional centred die pad. These dies are positioned closer to one end of the die pad than to the other. This produces an off-centre chip on a centred die pad. The off-centre chip prevents wires from one contact point on the die from crossing wires to another contact point or from crossing another contact leg which would short out the wire rendering the chip defective.

However, placing the die at the extreme edge of one side of the die pad rather than in a centred position on the die pad requires a slower, more exacting manufacturing technique. It also produces some wires that exceed suggested assembly standard lengths. Other wires, which extend to contact pads on the end of the chip positioned on the extreme edge of the die pad, have a very short distance between the pin and the contact pad. These wires are forced to bow upward creating an excessive loop height which causes problems during the molding procedure. As a result, assembly yield goes down.

The present invention provides a semiconductor lead frame comprising a die pad having two opposed edges, each edge being connected to a respective one of first and second carrier strips, and a plurality of contact legs adjacent to and spaced from the edges of the die pad, characterised in that said die pad is positioned to be closer to the first carrier strip than to the second carrier strip whereby the die pad is off-centred.

In an embodiment, wherein a die is positioned on the die pad and is connected by a plurality of bonding wires to said contact legs, said die is centred on said die pad and said contact legs are positioned such that all of said bonding wires are substantially equal in length and do not cross over each other

Embodiments of the present invention will hereinafter be described, by way of example, with reference to the accompanying drawings, in which:-

FIG. 1 is a plan view of a conventional lead frame having a die pad centred between two carrier strips;

FIG. 2 is a plan view of a lead frame of the present invention having a die pad positioned off-centre between two carrier strips;

FIG. 3 is a plan view of a conventional lead frame having a centred die pad upon which a die is positioned off-centre;

FIG. 4 is a plan view of a lead frame of the invention having an off-centred die pad upon which an end only wire bonding chip has been centred;

FIG. 5 is a view taken substantially along line 5-5 of FIG. 2 which shows a depressed die pad; and

FIG. 6 is a perspective view of an assembled semiconductor package.

In the drawings, the same reference numerals have been used throughout to refer to the same parts.

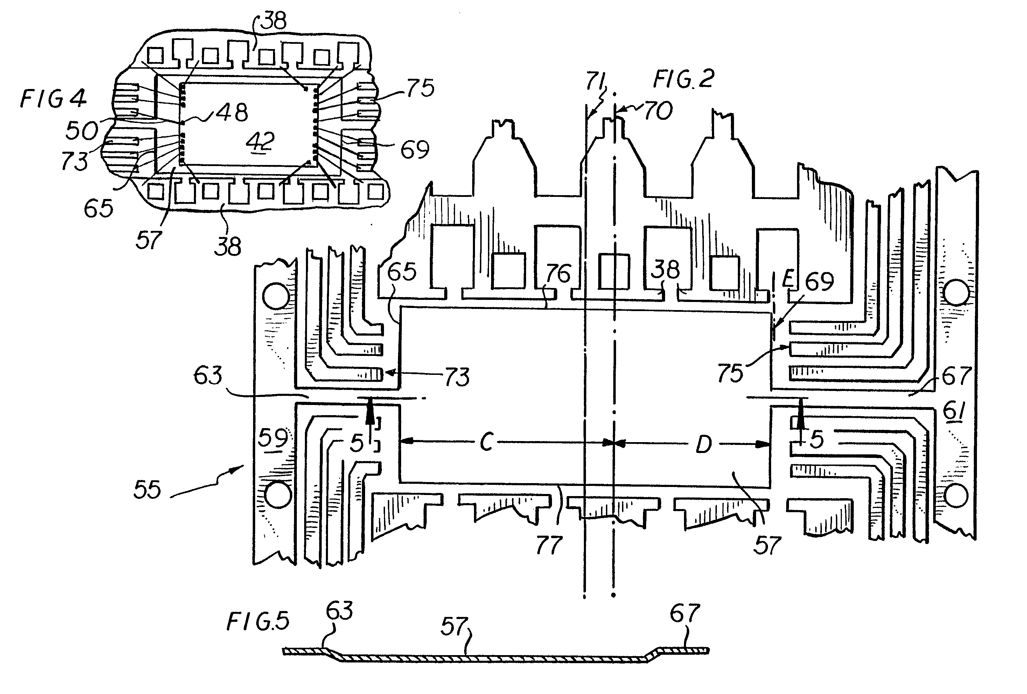

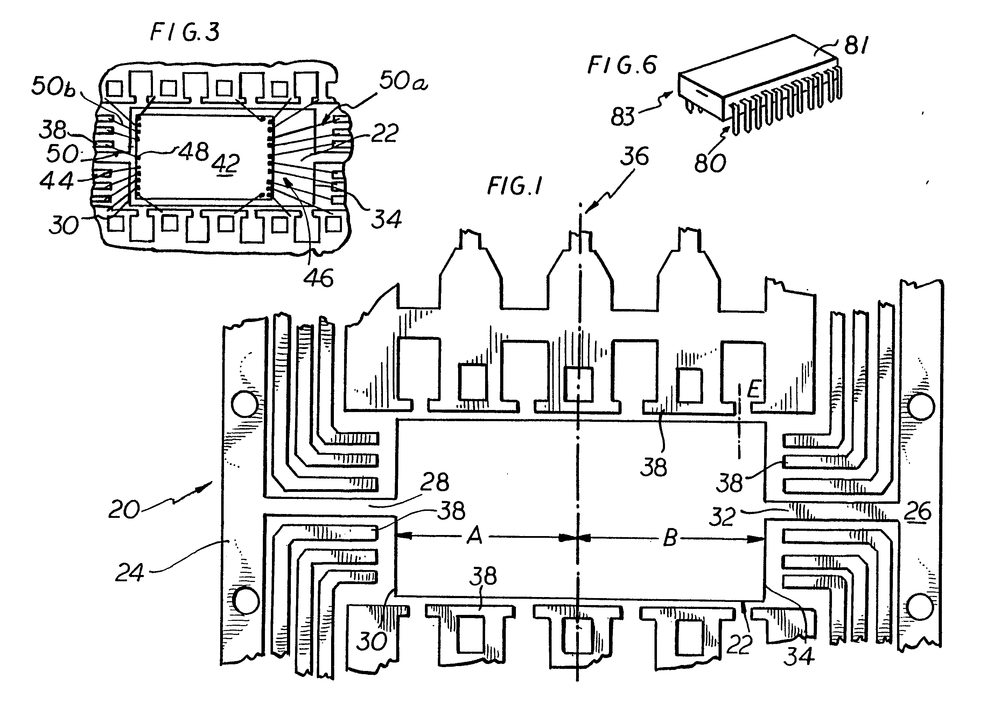

FIG. 1 shows a conventional lead frame 20 having a standard centred die pad 22 as used in standard dual inline package (D.I.P.) lead frames for general semiconductor use. Centred die pad 22 is positioned equally between parallel first and second carrier strips 24 and 26. A first bridge arm 28 extends from the first carrier strip 24 to a first short side 30 of the centred die pad. A second bridge arm 32 equal in length to the first bridge arm 28 extends from the second carrier strip 26 to a second short side 34 of the centred die pad. In this manner, the conventional die pad 22 is effectively centred between the first carrier strip and the second carrier strip as indicated by a broken line 36, which indicates both the centre line of the lead frame and the centre line of the die pad. As depicted in FIG. 1, the distance A from the centre line 36 to the short side 30 is equal to the distance B from the centre line 36 to the short side 34 when the die pad is centred between the two carrier strips.

A plurality of contact legs 38 are formed adjacent to the edges of the centred die pad 22. As will be explained below, wires will be extended from these contact legs to make contact with contact pads on a die positioned on the die pad.

Conventional centred die pad 22 is adequate for die which have wire bonding contact points on all of their four sides. In the case of some die, such as memory chips, the die are arranged for "end-only wire bonding". To avoid electrical shorting between wire contacts, such a die must be positioned at the extreme edge of the die pad.

FIG. 3 shows a conventional end-only wire bonding die 42, such as a memory chip, positioned adjacent to the short end 30 of a conventional centred die pad 22. A plurality of contact pads 48 are arranged on the surface of the chip at opposite ends 44 and 46 thereof. Each contact pad 48 corresponds to one contact leg 38. Bonding wires 50 extend from each contact leg 38 to the corresponding contact pad 38 on the chip 42. The chip 42 must be positioned substantially adjacent to one short end (shown as the short end 30 in FIG. 3) in order to prevent a bonding wire extending from a contact leg to its corresponding contact pad from crossing over the shorting either another contact leg or another bonding wire.

This off-centre positioning of the chip 42, however, results in excessively long bonding wires 50a extending to the contact pads along the second short side 34 of the conventional die pad 22. Similarly, very short bonding wires 50b extend from contact legs to the corresponding contact pads along the first short side 30. Short wires tend to bow upwards (not shown) creating problems during the molding process when the die pads, die, and bonding wires are encased in a plastic or epoxy compound (not shown). They can extend to an excessive height and fail to be encased in the plastic or epoxy compound covering. This is a defect which decreases the yield in a production run.

To achieve high yield in semiconductor production, bonding wires should be substantially of the same length. However, as illustrated in FIG. 3, the necessity of placing an end-only wire bonding chip adjacent to one end of the die pad produces both excessively long bonding wires and excessively short bonding wires and this causes a drop in production yield because of the above described defects in the chip. Further, positioning of a chip in an off-centre position, such as illustrated in FIG. 3, requires more time and care in the chip placement operation. Forcing the chip towards one end of the die pad can force the adhesive used for attaching the die to the die pad to collect at one end (not shown) and short out the short bonding wires 50b.

A semiconductor assembly which overcomes these problems is illustrated in FIG. 2 and comprises a lead frame 55 having an off-centre die pad 57. As is conventional, the off-centre die pad 57 is positioned between parallel first and second carrier strips 59 and 61. A short bridge arm 63 is integral with the first carrier strip 59 and with a first short side 65 of the die pad. A long bridge arm 67 is integral with the second carrier strip 61 and with a second short side 69 of the die pad. Together, short bridge arm 63 and long bridge arm 67 secure die pad 57 in an off-centre position between the two opposing, parallel carrier strips. A broken line 70 in FIG. 2 illustrates the centre line of lead frame 55. A broken line 71 of FIG. 2 illustrates the centre line of the off-centre die pad 57. Preferably, the die pad 57 is offset substantially 0.75mm (0.30 inch) from the centre line 70. As a result, the distance C from the short side 65 to the centre line 70 is longer than the distance D from the short side 69 to the centre line 70. Preferably, the distance C is substantially 5.0mm (0.200 inch) and the distance D is substantially 3.5mm (0.14 inch). This off-set can be more clearly seen by comparing the relationship between die pad 57 and broken line E in FIG. 2 and die pad 22 and broken line E in FIG. 1.

The lead frame 55 of FIG. 2 is formed from a flat sheet (not shown) or ribbon of conductive material such as alloy-42 or copper or an alloy-42/copper clad material. Alloy-42, available from Allegheny Ludlum Steel Company of Pittsburgh, Pennsylvania, is an alloy known in the art consisting of 42% nickel and 58% iron. Portions of the flat sheet are then removed from between the opposing outside edges of the ribbon to form the rectangular off-centre die pad 57 positioned closer to a first carrier strip 59, than to a second carrier strip 61. After these portions are removed, short bridge arm 63 and long bridge arm 67 remain to secure off-centre die pad 57 closer to the first carrier strip 59 than to the second carrier strip 61.

Contact legs are formed about all four sides of the off-centre die pad 57 by removing additional portions of the sheet adjacent to the off-centre die pad 57. To accommodate the offset, short contact legs 73 are provided at one short side 65 and long contact legs 75 are provided at the opposite short side 59. Conventional contact legs 38 are formed adjacent to the remaining two long sides 76, 77. In a preferred embodiment, the short ends 65, 69 are substantially 4mm (0.16 inch) in length, and the long sides 76, 77 are substantially 8.5mm (0.340 inch) in length. Each contact leg is formed to terminate in a pin 80 (shown in FIG. 6) projecting away from the die pad on either of opposing long sides 76, 77.

As shown in FIG. 5, the die pad 57 is preferably depressed downwardly from the plane formed by the first carrier strip 59 and the second carrier strip 61. The die pad depression is of the order of 0.375mm (0.015 inch). A die positioned on the depressed pad is then ready for the wire bonding connections. The depressed die pad allows contact pads on the die surface to be positioned in substantially the same plane as that formed by the contact legs positioned around the die pad. This provides for more efficient connections of bonding wires between contact legs and contact pads.

FIG. 4 shows an off-centre die pad 57 having an end-only wire bonding die 42 centred on the off-centre die pad 57. This permits bonding wires 50 to all be substantially of the same length regardless of whether they extend over first short end 65 or second short end 69. Centering of the die 42 allows bonding wires extending from the conventional contact legs 38 or from the short contact legs 73 or long contact legs 75 to contact a corresponding contact pad 48 without crossing over or shorting to a second contact leg or a second bonding wire. As the bonding wires 50 are substantially all of the same length, fewer defective bonds are created and production yield goes up. Further, the centering of a chip is an easier operation than positioning a chip at the extreme edge of the die pad. As a result, it is performed more quickly and efficiently than positioning the chip in an off-centred position. This leads to faster production, and higher yield on each production run.

After the wire bonding process is complete, the die, die pad, contact legs and connecting wires are then encased in a plastic or epoxy compound 81 as illustrated in FIG. 6. The centre strips are separated from the epoxy covered off-centre die pad and the pins 80 are electrically isolated and extended downwardly from the epoxy body 81 to form an assembled semiconductor package.

It will thus be seen that the present invention is able to provide lead frames in a continuous strip, each lead frame having a die pad which is offset or asymmetrical from the centre line of the strip to facilitate improved wire bonding.

## Claims

1. A semiconductor lead frame comprising a die pad (57) having two opposed edges (65,69), each edge being connected to a respective one of first and second carrier strips (59,62), and a plurality of contact legs (38,73) adjacent to and spaced from the edges of the die pad (57), characterised in that said die pad is positioned to be closer to the first carrier strip (59) than to the second carrier strip (61) whereby the die pad is off-centred.

2. A lead frame as claimed in Claim 1, wherein a die (42) is positioned on the die pad (57) and is connected by a plurality of bonding wires (50) to said contact legs (38,73), characterised in that said die (42) is centred on said die pad (57) and said contact legs (38,73) are positioned such that all of said bonding wires (50) are substantially equal in length and do not cross over each other.

3. A lead frame as claimed in Claim 2, wherein each bonding wire (50) connects a contact leg (38,73) to a corresponding contact pad (48) formed on the die (42), and wherein no bonding wire (50) extending between one contact leg and a corresponding contact pad crosses another contact leg.

4. A lead frame as claimed in Claim 3, wherein said die (42) has contact pads (48) only on two opposed ends thereof.

5. A lead frame as claimed in any preceding claim, wherein said die pad (57) is positioned substantially 0.75mm nearer to said first carrier strip (59) than to said second carrier strip (61).

6. A lead frame as claimed in any preceding claim, wherein said die pad (57) is depressed below a plane formed by said first and second carrier strips (59,61).

7. A lead frame as claimed in any preceding claim, wherein said die (42) is a memory chip.

8. A lead frame as claimed in any preceding claim, wherein said die pad (57) is rectangular having two opposed long edges (76,77) and two opposed short edges (65,69), wherein said carrier strips (59,61) extend substantially parallel to each other, and each short edge (65,69) is integrally formed with a respective carrier strip.

9. A lead frame as claimed in Claim 8, wherein said contact legs (38,73) are spaced from and positioned generally around said die pad (57).

10. A method of making lead frame comprising the steps of:
removing portions of a flat sheet of conductive material between opposing outside edges of the sheet to form a rectangular portion having opposing long sides and opposing short sides, the rectangular portion positioned closer to a first ouside edge than to a second outside edge, the rectangular portion being integrally connected by opposing short sides of said rectangular portion to said outside edges; and
establishing a plurality of contact legs configured to be adjacent to and substantially equally spaced from one of either the opposing long edges or the opposing short edges of the rectangular portion, the contact legs formed between the first outside edge and the rectangular portion being shorter than the contact legs formed between the second outside edge and the rectangular portion.

11. A method as claimed in Claim 10 further comprising the step of depressing said rectangular portion below said plane formed by said outside edges.

12. A method as claimed in Claim 10 or 11, further comprising the step of forming said rectangular portion substantially 0.75mm closer to said first outside edge than to said second outside edge.

13. A method as claimed in any of Claims 10 to 12, further comprising the step of attaching a die to said rectangular portion.

14. A method as claimed in Claim 13, wherein said die is centred on said rectangular portion.

15. A method as claimed in Claim 13 or 14, wherein said die is arranged for end only wire bonding.

16. A method as claimed in any of Claims 13 to 15, wherein said die is a memory chip.

17. An assembled semiconductor package comprising:

a die located on a die pad;

plural legs spaced from and positioned generally around said die pad, wherein some of said legs on one side of said die pad are shorter than said legs on an opposing side of said die pad;

plural wires extending from said die to said legs for electrical connection; and

a casing surrounding said die, die pad, wires and parts of said legs.

FIG.2

FIG.4

FIG.5

FIG.3

50b

50a

38

50

44

48 42

22

30

34

46

FIG.6

81

83

80

36

FIG.1

20

24

28

38

30

A

B

38

38

38

32

26

22

34

E

0 242 962

## DOCUMENTS CONSIDERED TO BE RELEVANT

| Category | Citation of document with indication, where appropriate, of relevant passages | Relevant to claim | CLASSIFICATION OF THE APPLICATION (Int. Cl 4) |
|---|---|---|---|
| X | PATENT ABSTRACTS OF JAPAN, vol. 9, no. 258 (E-350)[1981] 16th October 1985; & JP-A-60 107 851 (TOSHIBA K.K.) 13-06-1985 * Abstract * | 1-4,7-10,13,14,16,17 | H 01 L 23/48 |
| Y | Idem --- | 6,11 | |
| X | PATENT ABSTRACTS OF JAPAN, vol. 9, no. 244 (E-346)[1967], 30th September 1985; & JP-A-60 94 750 (HITACHI SEISAKUSHO K.K.) 27-05-1985 * Abstract * --- | 1-3,8-10,13,17 | |
| Y | DE-A-2 159 530 (PHILIPS) * Page 9, lines 8-27 * --- | 6,11 | |
| A | EP-A-0 114 531 (FUJITSU) * Figure 8; page 6, line 34 - page 7, line 28 * --- | 1-3,8-10,13-15,17 | TECHNICAL FIELDS SEARCHED (Int. Cl 4) H 01 L |
| A | PATENT ABSTRACTS OF JAPAN, vol. 5, no. 192 (E-85)[864], 8th December 1981; & JP-A-56 115 551 (NIPPON DENKI K.K.) 10-09-1981 * Abstract * --- -/- | 1,8-10,17 | |

The present search report has been drawn up for all claims

| Place of search | Date of completion of the search | Examiner |
|---|---|---|
| THE HAGUE | 06-07-1987 | CAMPLING N.C.G. |

European Patent Office

## DOCUMENTS CONSIDERED TO BE RELEVANT

Page 2

| Category | Citation of document with indication, where appropriate, of relevant passages | Relevant to claim | CLASSIFICATION OF THE APPLICATION (Int Cl 4) |
|---|---|---|---|
| X | PATENT ABSTRACTS OF JAPAN, vol. 9, no. 123 (E-317)[1846], 28th May 1985; & JP-A-60 10 651 (TOSHIBA K.K.) 19-01-1985 * Abstract * --- | 1-5,8-10,12-15,17 | |
| A | Idem --- ----- | 7,16 | |

TECHNICAL FIELDS SEARCHED (Int. Cl 4)

The present search report has been drawn up for all claims

| Place of search | Date of completion of the search | Examiner |
|---|---|---|
| THE HAGUE | 06-07-1987 | CAMPLING N.C.G. |

EPO Form 1503 03 82